Europäisches Patentamt

European Patent Office

Office européen des brevets

(19)

(11) Publication number: **0 026 639**
**A2**

(12) **EUROPEAN PATENT APPLICATION**

(21) Application number: 80303369.5

(22) Date of filing: 25.09.80

(51) Int. Cl.³: **H 04 L 7/02**
**H 04 L 27/00**

(30) Priority: 27.09.79 US 79653

(43) Date of publication of application:
08.04.81 Bulletin 81/14

(84) Designated Contracting States:
BE DE GB IT NL SE

(71) Applicant: COMMUNICATIONS SATELLITE
CORPORATION
950 L'Enfant Plaza
S.W. Washington, D.C. 20024(US)

(72) Inventor: Uzunoglu, Vasil
2830 Fox Mound Road
Ellicott City, Maryland(US)

(74) Representative: Jennings, Guy Kenneth et al,
GILL JENNINGS & EVERY 53/64 Chancery Lane
London WC2A 1HN(GB)

(54) Clock recovery network.

(57) A clock recovery network comprises a synchronised voltage controlled oscillator 10 which receives the input data stream and provides at its output a clock signal synchronised with the input data stream. The tuned centre frequency of the oscillator is controlled by a coarse tuning signal in the form of a voltage proportional to the incoming symbol rate, supplied through an integrator 14 by a frequency-to-voltage converter 12 receiving the input data stream as its input. The coarse tuning signal determines the appropriate frequency range at which the oscillator 10 should operate and the oscillator is then positively synchronised to the frequency $f_1$ of the incoming data stream.

./...

EP 0 026 639 A2

# FIG 1

GJE/180/118

Communications Satellite Corporation

- 1 -

Clock recovery network

In conventional modems, the clock recovery network has been designed to operate at high frequencies, e.g., above 10 MHz, or low frequencies. The high frequency clock recovery networks have proven quite acceptable but typically utilise delay elements. To operate these high frequency clock recovery circuits at lower frequencies requires that larger delay elements be utilised and below approximately 10 MHz the required size of the delay element becomes unacceptable. For this reason, separate clock recovery networks have been designed for low frequency systems, these low frequency clock recovery networks typically incorporating phase lock loops with multiple control elements whose repeated adjustments become tedious and are often impractical.

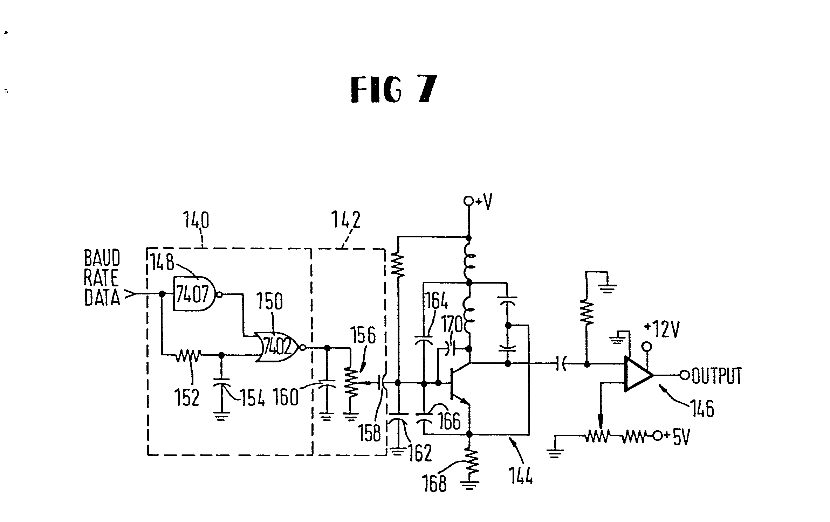

A clock recovery network which overcomes this difficulty is shown in Figure 7 of the accompanying drawings and is effectively useful at both low and high frequencies. It comprises a pulse forming network 140 includes a 7407 NAND gate 148 which receives the baud rate data and provides one input to a 7402 NOR gate 150. The baud rate data signal is simultaneously provided to the other input of the NOR gate 150 through an RC network comprising resistor 152 and capacitor 154. The output of gate 150 will be a pulse train at the baud rate, and the values of resistor 152 and capacitor 154 are selected so that the pulses at the output of gate 150 will be suitably narrow.

The narrow pulse train is supplied to the potentiometer 156 which determines the amplitude of the synchronisation pulse to be applied to the oscillator. The width and shape of the pulse will be determined by the capacitor 158. The capacitors 160 and 162 form a bandpass filter to improve the signal-to-noise ratio and reduce the jitter of the pulse applied to the oscillator.

The oscillator 144 may be a standard Colpitt's oscillator with two additional positive and negative feedbacks. The capacitors 164 and 166 constitute the additional positive feedback paths which improve the regeneration and which, in turn, improve the Q stability of the oscillator. The resistor 168 and the capacitor 170 improve the frequency and amplitude stability of the clock recovery network by de-sensitising the oscillator stage to input and temperature variations. The tuned oscillator circuit should be isolated from the input as much as possible. For this purpose, it may be advisable to connect an amplifier between potentiometer 156 and capacitor 158. Due to the possibility of prolonged ones or zeros in the incoming data stream, unstable oscillators may drift by an amount sufficient to adversely affect the bit error rate. Thus, the Q and frequency stability of the system are essential. These can be further improved by using a non-minimum phase shift network as a tuning element where d$\phi$/d$\omega$ is large.

The present invention relates to an improvement in the clock recovery network shown in Figure 7 and is directed to the use of such a clock recovery network in a universal modem. In present modems, the clock recovery network is designed to operate only at a single frequency and in order to accommodate different bit rates, the clock recovery network must be replaced. Even in the clock recovery network of Figure 7 the synchronised voltage control oscillator (SVCO) is tuned to a centre frequency in the vicinity of the clock frequency to be recovered, and the incoming data stream is then used to positively synchronise the oscillator with the incoming data. If a different bit rate is to be employed, the oscillator would have to be replaced with a different oscillator tuned to a different centre frequency. This requirement of replacing the clock recovery network in order to accommodate different bit rates can be quite troublesome in a universal modem which may be operated frequently at different bit rates.

It is therefore an object of this invention to provide a clock recovery network which will accommodate a broad bit rate spectrum without the necessity of any replacement or re-adjustment of the network circuitry.

Briefly, this is achieved according to the present invention by utilising voltage controlled resistors to determine the tuned centre frequency of the oscillator, and by applying to these voltage controlled resistors a voltage proportional to the incoming bit rate. This voltage will serve as a coarse tuning signal to bring the frequency of the SVCO in the approximate frequency range at which it should operate, and the oscillator will then be synchronised to the incoming data by synchronising pulses generated from the incoming data. The coarse tuning signal can be generated by a frequency-to-voltage (F/V) converter, and the voltage controlled resistors may comprise field effect transistors (FETs). In this way, a single clock recovery network can be used at both low and high frequencies and can accommodate a variety of incoming bit rates without the necessity of any re-adjustment or replacement of circuit components.

In the drawings:-

Figure 1 is a block diagram of a universal clock recovery network according to the present invention;

Figure 2 is a schematic diagram of the synchronised voltage controlled oscillator illustrated in Figure 1;

Figure 3 is a graph of $R_D S$ versus $V_G S$ for the FETs illustrated in Figure 2;

Figure 4 is a graph of the tuned centre frequency versus $V_G S$ for the voltage controlled oscillator of Figure 2;

Figure 5 is a graph of a typical input-output relationship for a frequency-to-voltage converter;

Figure 6 is a schematic diagram of a conventional frequency-to-voltage (F/V) converter which may be used in the clock recovery network of Figure 1;  and

Figure 7 is a schematic diagram of a clock recovery network upon which the present invention is an improvement.

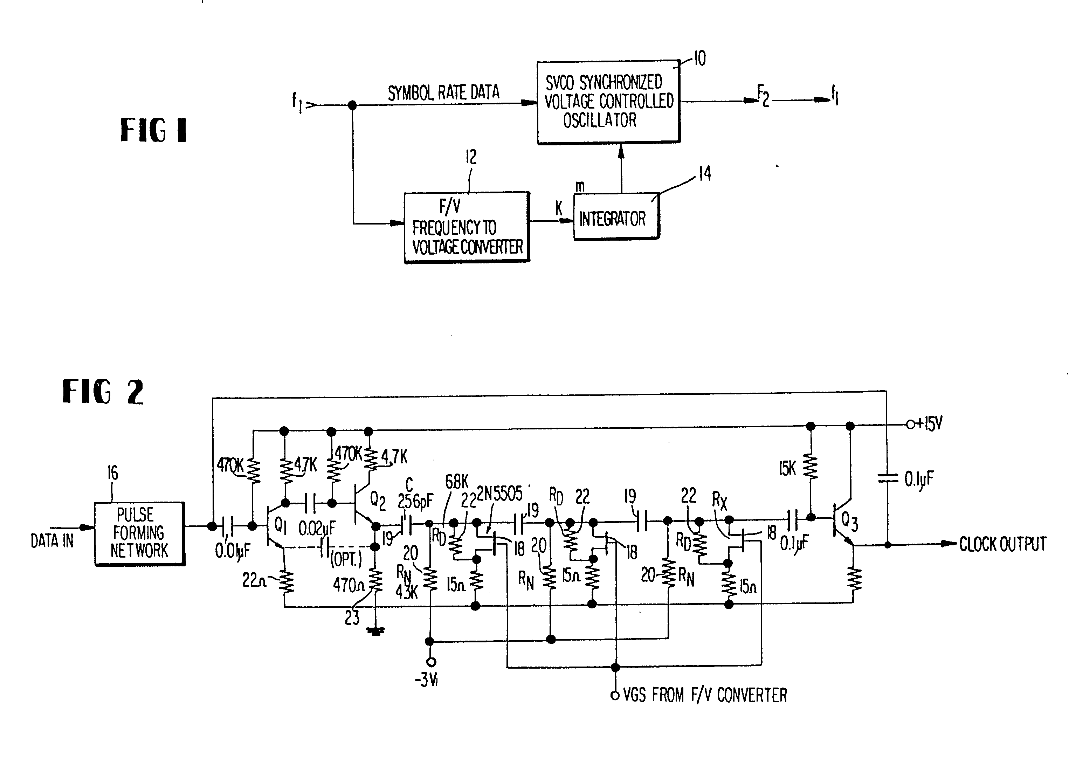

Figure 1 is a block diagram of the essential components of a universal clock recovery network according to the present invention. Recovered data, from P or Q channels with a repetition rate $f_1$, is applied simultaneously to the input of SVCO 10 and to the input of F/V 12. The F/V 12 generates a voltage proportional to the frequency of the externally applied signal and provides this through an integrator 14 to a coarse control input of the SVCO 10. This coarse control signal determines the approximate frequency range at which the oscillator 10 should operate, and the oscillator will then be entrained to the frequency $f_1$ by the incoming data in the manner described with reference to Figure 7. Due to non-linearities in the F/V converter and the components in the oscillator 10, the voltage established by the converter 12 cannot bring the free-running frequency of the oscillator precisely to $f_1$. However, the output voltage of converter 12 must bring the oscillator 10 within the pull-in range of the external frequency $f_1$.

Figure 2 is a schematic diagram of a SVCO circuit suitable for use in the clock recovery network according to the present invention. The oscillator illustrated in Figure 2 is an RC phase shift oscillator which, although it differs in structure from the oscillator circuitry of Figure 7, utilises the same principle of synchronisation by means of the incoming data. The pulse forming network 16 shown in Figure 2 may be identical to that disclosed in Figure 7. The oscillator of Figure 2 is less sensitive to pulse width and amplitude variations than the oscillator of Figure 7 and, therefore, no amplitude and pulse width determining circuit 142 is necessary for proper operation. However, at higher frequencies it may be advisable to use such a circuit between the pulse forming network and the oscillator input. The recovered clock signal is fed back from the emitter of transistor $Q_3$ to the output of the pulse forming network where it is combined with the synchronising pulses derived from the incoming data stream and supplied to the base of transistor $Q_1$ to control the oscillating frequency thereof.

To obtain the bit rate clock, the SVCO is tuned to twice the frequency of the symbol clock rate or, alternatively, the pulse forming network may incorporate a pulse doubling network in which case the SVCO is tuned to the symbol clock rate. The free-running frequency of the SVCO illustrated in Figure 2, in the absence of any externally applied synchronising pulses is given by:

$$f_o = \frac{1}{2\pi\sqrt{6R_xC}} \tag{1}$$

where $R_x$ is the channel resistance of the field effect transistors 18, and C is the capacitance of the $R_xC$ phase shift network determined primarily by capacitors 19. $R_x$ is determined by the control voltage applied to the gates of the field effect transistors 18, this control voltage being derived from the output of F/V converter 12 and being proportional to the input frequency $f_1$.

The integrator 14 in Figure 1 is provided for the purpose of adding some memory to the SVCO so that the oscillator will continue to operate within the proper frequency range even in the presence of continuous 1's or 0's in the incoming data stream. This integrator may not be necessary in all cases, since some memory is already incorporated into the converter 12.

A buffer stage transistor $Q_3$ is added to the SVCO to linearise equation (1). Equation (1) indicates that the frequency versus $R_x$ varies asymptotically, and the non-linear nature of the curve is evident. Resistors 20 are added to the $R_xC$ phase shift network so that the field effect transistors have a dc return path, and a positive potential is applied to the resistors 20 so that the field effect transistors are not forward biased due to the signal across resistor 23.

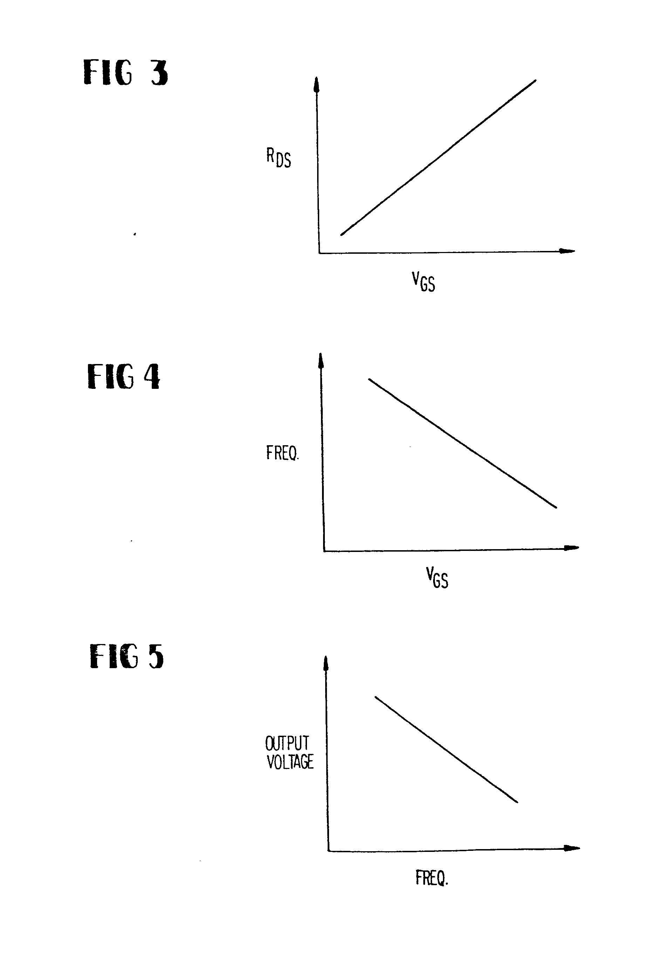

Figure 3 generally illustrates the characteristics of $R_{DS}$ versus $V_{GS}$ of a JFET with $R_{DS}$ across the source and drain. The resistors 22 are added across the source and drain of the transistors 18 in order to linearise the $R_{DS}$ versus $V_{GS}$ characteristics.

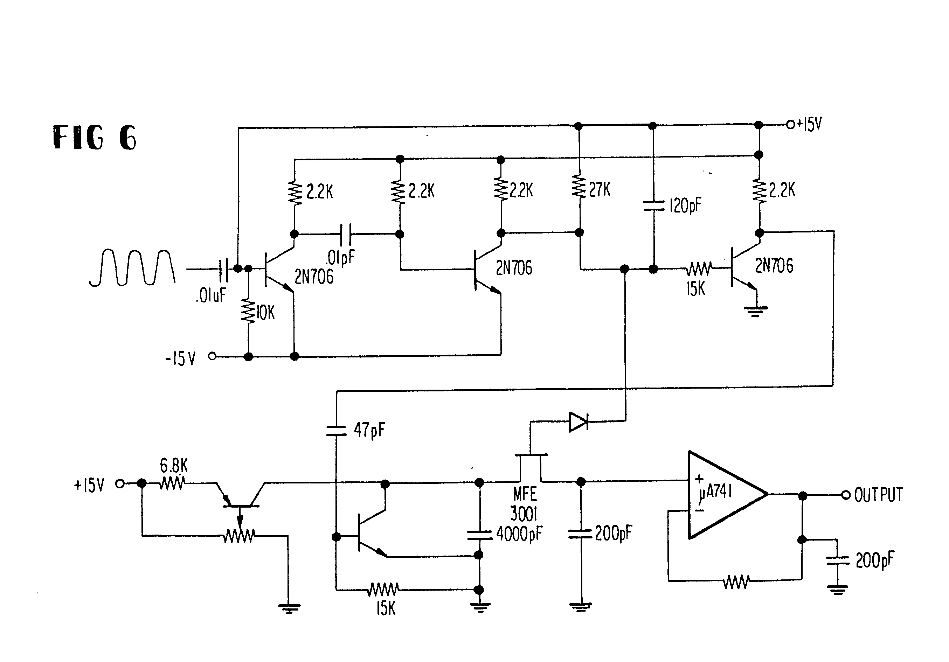

Figure 4 generally illustrates the centre frequency versus $V_{GS}$ for the oscillator circuit shown in Figure 2. As $V_{GS}$ increases, the tuned centre frequency decreases and, therefore, the F/V converter 12 must generate an output voltage which is inversely proportional to frequency. Thus the output voltage versus input frequency characteristic of the F/V converter 12 must be as generally illustrated in Figure 5. It should be noted that the linearity of Figure 5 holds for sinusoidal inputs, and that any other waveform will introduce some non-linearity.

However, this non-linearity is of no great significance since the SVCO is only coarsely tuned by the output voltage of converter 12, and is actually synchronised by the external frequency $f_1$.

A typical example of a F/V converter suitable for use in the present invention is shown in Figure 6 and is described by Vasil Uzunoglu, "Analysis Design of Digital Systems", Gordon and Breach Book Company, 1974, page 106. Although a JFET was used in experiments, it is easily appreciated that this transistor could be readily replaced with a MOSFET.

It is apparent from equation (1) that the change in tuned centre frequency of the oscillator is inversely proportional to $R_x$ which is the source-to-drain resistance of the JFET. A variation of approximately four octaves in $R_x$ is feasible in a JFET without any practical limitations, and this number may even go higher for MOSFETs.

The $R_xC$ components of the SVCO including the JFETs can be integrated on a single chip, whereas the transistors can be integrated on a second chip. The F/V converters are already available as integrated elements. Thus, the entire structure can be realised as high bit element consisting of three to four chips. It is apparent that the present invention will simplify the operation of a universal modem, as well as reduce its cost and size by effectively accommodating a variety of incoming bit rates. With the universal clock recovery network according to the present invention, it is possible to build universal modems which can operate in a bit rate range of several octaves without replacing the clock recovery network, nor are there any mechanical adjustments required.

C L A I M S

1.      A clock recovery network for receiving an input data stream having a symbol clock rate and providing as an output a clock signal synchronized with the input data stream, the network comprising an oscillator for receiving the input data stream and providing at its output a clock signal synchronised with the input data stream, the oscillator being synchronised to the input data stream by means of synchronising pulses generated from the input data stream, the free-running frequency of the oscillator in the absence of the synchronising pulses being determined by a coarse control voltage and means for generating and providing to the oscillator a coarse control voltage corresponding to a desired output frequency of the clock recovery network.

2.      A clock recovery network according to claim 1 wherein the oscillator is a synchronised voltage controlled oscillator for receiving a synchronisation signal and providing a digital output clock synchronised to the synchronisation signal.

3.      A clock recovery network according to claim 2 wherein the oscillator includes a pulse-forming network for receiving the input data stream and generating therefrom a stream of synchronisation pulses.

4.      A clock recovery network according to claim 3, wherein the output of the oscillator is fed back and combined with the output of the pulse-forming network.

5.        A clock recovery network according to any one of the preceding claims wherein the coarse control voltage corresponds to approximately twice the frequency of the symbol clock rate.

6.        A clock recovery network according to any one of the preceding claims wherein the oscillator includes at least one variable resistance unit the resistance of which determines the free-running frequency of the oscillator.

7.        A clock recovery network according to claim 6, wherein the variable resistance unit comprises a number of variable resistance elements connected in parallel.

8.        A clock recovery network according to claims 6 or 7 wherein the variable resistance unit comprises a field effect transistor.

9.        A clock recovery network according to any one of the preceding claims wherein the coarse control voltage generating means comprises a frequency-to-voltage converter for receiving an input signal and providing a coarse control voltage corresponding to the frequency of the input signal, the frequency-to-voltage converter receiving the input data stream as its input signal.

10.        A clock recovery network according to claim 9 further comprising integrator means coupled between the frequency-to-voltage converter and the oscillator whereby the oscillator will continue to operate at the desired output frequency even during the absence of an output from the frequency-to-voltage converter.

# FIG I

f₁ — SYMBOL RATE DATA — SVCO SYNCHRONIZED VOLTAGE CONTROLLED OSCILLATOR — 10 — F₂ — f₁

12 — F/V FREQUENCY TO VOLTAGE CONVERTER — K — m — INTEGRATOR — 14

# FIG 2

DATA IN — 16 — PULSE FORMING NETWORK

+15V

470K  4.7K  470K  4.7K  15K  0.1μF

0.01μF  Q₁  0.02μF  Q₂  C 256pF  6.8K  2N5505  R_D 22  19  22  R_X  0.1μF  Q₃

CLOCK OUTPUT

22Ω  470Ω (OPT.)  19  R_D  20  R_N 4.3K  15Ω  18  20  R_N  15Ω  18  20  R_N  R_D  15Ω  18

23

-3V₁

VGS FROM F/V CONVERTER

1/4

0026639

0026639

FIG 3

$R_{DS}$

$V_{GS}$

FIG 4

FREQ.

$V_{GS}$

FIG 5

OUTPUT
VOLTAGE

FREQ.

FIG 6

# FIG 7